(19) Europäisches Patentamt
European Patent Office
Office européen des brevets

(11) Veröffentlichungsnummer: **0 599 068 A2**

(12) **EUROPÄISCHE PATENTANMELDUNG**

(21) Anmeldenummer: **93117314.0**

(51) Int. Cl.$^5$: **G03F 7/027**

(22) Anmeldetag: **26.10.93**

(30) Priorität: **26.11.92 DE 4239661**

(43) Veröffentlichungstag der Anmeldung: **01.06.94 Patentblatt 94/22**

(84) Benannte Vertragsstaaten: **BE DE ES FR GB IT**

(71) Anmelder: **BASF Lacke + Farben AG**
**Glasuritstrasse 1**
**D-48165 Münster-Hiltrup(DE)**

(72) Erfinder: **Kingma, Arend Jouke, Dr.**
**Ruedigerstrasse 48**
**D-67069 Ludwigshafen(DE)**
Erfinder: **Bronstert,Bernd, Dr.**
**Zanderstrasse 35**
**D-67166 Otterstadt(DE)**
Erfinder: **Scherr, Guenter, Dr.**
**An der Mittagsweide 17**
**D-67065 Ludwigshafen(DE)**
Erfinder: **Steuerle, Ulrich, Dr.**
**Heckerstrasse 33**
**D-69124 Heidelberg(DE)**

(74) Vertreter: **Karau, Wolfgang, Dr. et al**
**BASF Aktiengesellschaft,**
**Patentabteilung ZDX - C 6**
**D-67056 Ludwigshafen (DE)**

(54) **Lichtempfindliches Aufzeichnungsmaterial.**

(57) Die Erfindung betrifft ein lichtempfindliches Aufzeichnungsmaterial, das in einer Schichtdicke < 10 µm auf einen Träger aufgebracht ein Gemisch aus
(a) polymeren Bindemittel
(b) photopolymerisierbarer ethylenisch ungesättigter organischer Verbindung,
(c) Photoinitiator oder Photoinitiatorsystem
und
(d) einem Weichmacher
enthält, wobei als Weichmacher ein Polyalkyleniminderivat eingesetzt wird.

Dieses Aufzeichnungsmaterial eignet sich zur Herstellung von Hochdruckplatten.

EP 0 599 068 A2

Die Erfindung betrifft ein lichtempfindliches Aufzeichnungsmaterial, das auf einen Träger aufgebracht ein Gemisch aus polymerem Bindemittel, photopolymerisierbarer ethylenisch ungesättigter organischer Verbindung, Photoinitiator und einen bestimmten Weichmacher enthält. Dieses Aufzeichnungsmaterial eignet sich insbesondere zur Herstellung von Hochdruckplatten.

Negativ arbeitende lithographische Druckplatten, bei welchen auf einem Träger ein Gemisch aus photovernetzbarem Polymer mit lichtempfindlichen Gruppen in der Gerüstkette, Poly[1,4-cyclohexylenbis-(oxyethylen)-p-phenylendiacrylat]-co-3,3'-{[natriumimino]di-sulfonyl}-di-benzoat und einem Poly(N-propionyl-ethylenimin) aufgebracht ist, sind aus der US-A-5043250 bekannt. Desgleichen ist aus der US-A-5045432 eine strahlungsempfindliche Zusammensetzung für lithographische Druckplatten bekannt, die Poly-(N-acylalkylenimin) und einen ungesättigten Polyester, wie p-Phenylendiacrylatpolyester, und einen Copolyester einer ungesättigten Dicarbonsäure und eines Oxyalkylenethers eines Alkylidendiphenols enthält.

Ferner sind in der JP-A-57108132 zwitterionische Polyethylenimine als Additive für thermoplastische Harze zur Verbesserung der elektrischen Eigenschaften beschrieben.

Aufgabe der vorliegenden Erfindung ist es, ein lichtempfindliches Aufzeichnungsmaterial aufzuzeigen, das für die Herstellung von Hochdruckplatten besonders gut geeignet ist. Weder diese noch die aus den Hochdruckplatten herzustellenden Druckformen sollen Klischeecurling aufweisen. Außerdem sollen damit exakte Bildwiedergabe und entsprechende Druckergebnisse erzielt werden.

Überraschenderweise läßt sich diese Aufgabe durch die erfindungsgemäßen lichtempfindlichen Aufzeichnungsmaterialien, die die im folgenden näher beschriebenen Weichmacher enthalten, lösen.

Gegenstand der vorliegenden Erfindung ist ein lichtempfindliches Aufzeichnungsmaterial, das in einer Schichtdicke > 10 $\mu$m auf einen Träger aufgebracht ein Gemisch aus

(a) mindestens einem polymeren Bindemittel,
(b) mindestens einer photopolymerisierbaren ethylenisch ungesättigten organischen Verbindung,
(c) einem Photoinitiator oder einem Photoinitiatorsystem und
(d) einem Weichmacher

enthält, das dadurch gekennzeichnet ist, daß als Weichmacher ein Polyalkyleniminderivat eingesetzt wird, das Strukturelemente A oder B oder ein Gemisch aus Strukturelementen A und B aufweist, wobei

A = 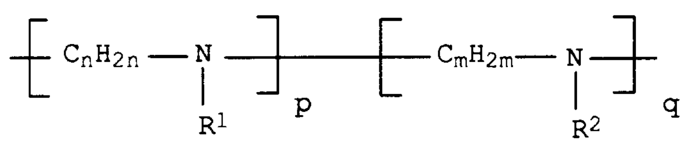

mit

| | |
|---|---|
| n = | 2 bis 8, |
| m = | 2 bis 8, |
| p = | 10 bis 10 000, |
| q = | 10 bis 10 000, |
| $R^1$ und $R^2$ | untereinander gleich oder verschieden sind und für |

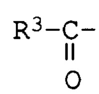

oder $R^3$ oder A stehen,

$R^3$ = ein, gegebenenfalls ethylenisch ungesättigter, 1 bis 30 Kohlenstoffatome enthaltender linearer, verzweigter oder cyclischer aliphatischer und/oder aromatischer Kohlenwasserstoffrest,

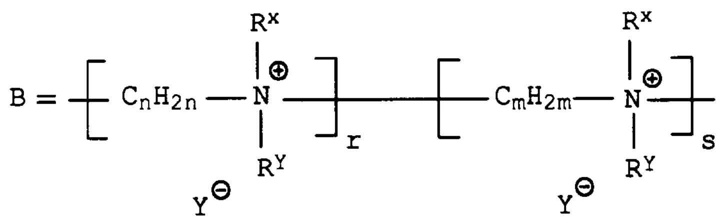

mit

n = 2 bis 8,
m = 2 bis 8,
r = 10 bis 10 000,
s = 10 bis 10 000
$R^x$ = H, ein, gegebenenfalls ethylenisch ungesättigter, 1 bis 30 Kohlenstoffatome enthaltender linearer, verzweigter oder cyclischer aliphatischer und/oder aromatischer Kohlenwasserstoffrest,
$R^Y$ = Hydroxialkyl-, Hydroxioxaalkyl- oder Poly(hydroxy)oxaalkylrest mit 2 bis 500 Kohlenstoffatomen, $R^x$ oder B,
$Y^{\ominus}$ =

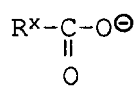

oder ein anderer monovalenter anionischer Rest.

Als polymere Bindemittel (a) können vorzugsweise teilverseiftes Polyvinylacetat oder teilverseiftes Polyvinylacetat-Polyalkylenoxid-Propfmischpolymerisat oder nachträglich polymeranalog acylierte Polyvinylalkohole oder deren Gemische sowie ein in Wasser, Wasser/Alkohol oder Alkohol lösliches Polyamid eingesetzt werden.

Als photopolymerisierbare ethylenisch ungesättigte organische Verbindungen (b) lassen sich vorzugsweise polyfunktionelle Acrylate oder Methacrylate einsetzen.

Als Weichmacherkomponenten (d) werden vorzugsweise solche Polyalkyleniminderivate eingesetzt, die aus Gemischen der Strukturelemente A und B bestehen, worin mindestens 70 mol-% Strukturelemente A enthalten sind.

Bevorzugt sind auch erfindungsgemäße Aufzeichnungsmaterialien, die aus einem Gemisch aus

10 bis 95 Gew.-% der Komponente (a),
0,5 bis 50 Gew.-% der Komponente (b),
0,2 bis 10 Gew.-% der Komponente (c) und
0,5 bis 50 Gew.-% der Komponente (d)

bestehen, wobei die Summe der unter (a) bis (d) genannten Prozentzahlen 100 ist.

Gegenstand der vorliegenden Erfindung ist außerdem ein Verfahren zur Herstellung von Hochdruckplatten, dadurch gekennzeichnet, daß als reliefbildende Schicht eine Schicht des erfindungsgemäßen Aufzeichnungsmaterials eingesetzt wird.

Der Einsatz des erfindungsgemäßen Polyalkyleniminderivate wirkt sich durch eine wesentliche Viskositätserniedrigung der Gießlösung sehr positiv bei der Verarbeitung aus, so daß Lösungen mit höheren Feststoffgehalten verarbeitet werden können. Weitere Vorteile der erfindungsgemäßen Aufzeichnungsmaterialien sind ein verringertes Klischeecurling (ungleichmäßige Verwerfung der Druckform) und eine Verbesserung der Auswaschbarkeit (verkürzte Auswaschzeiten).

Zu den Aufbaukomponenten des erfindungsgemäßen lichtempfindlichen Aufzeichnungsmaterials und zum erfindungsgemäßen Verfahren zur Herstellung der Hochdruckplatten ist im einzelnen folgendes auszuführen.

Als polymere Bindemittel (a) der erfindungsgemäßen Aufzeichnungsmaterialien kommen die hierfür allgemein üblichen in Wasser oder polaren organischen Lösungsmitteln, wie z.B. Methanol, Ethanol, Propanol, Isopropanol, Dimethylformamid, Dimethylsulfoxid oder deren Gemischen, gegebenenfalls auch

mit Wasser, löslichen polymeren Bindemittel in Frage.

Als bevorzugte Beispiele derartiger polymerer Bindemittel (a) sind zu nennen teilverseiftes Polyvinylacetat und teilverseiftes Vinylacetat/Alkylenoxid-Pfropfmischpolymerisat, oder nachträglich polymeranalog acyclierte Polyvinylalkohole, wie sie beispielsweise in EP 0079514, EP 0224164, EP 0226079 oder EP 0059988 beschrieben sind, sowie Gemische der oben genannten Polymerisate.

Ebenso eignen sich als polymere Bindemittel (a) in Wasser, Wasser/Alkohol oder in Alkohol lösliche Polyamide, wie sie beispielsweise in EP 0085472 oder DE 1522444 beschrieben sind.

Die polymeren Bindemittel sind im erfindungsgemäßen Aufzeichnungsmaterial vorzugsweise in Mengen von 10 bis 95, insbesondere 20 bis 80 Gewichts-%, bezogen auf die Gesamtmenge der Komponenten a) bis d), enthalten.

Als photopolymerisierbare ethylenisch ungesättigte organische Verbindungen (b) kommen die für lichtempfindliche Aufzeichnungsmaterialien allgemein üblichen in Frage, insbesondere die Ester der Acryl- und/oder Methacrylsäure mit ein- und vorzugsweise mehrwertigen Alkoholen, wie z.B. Estern der Acryl- oder Methacrylsäure mit Äthandiol, Propandiol, Butandiol, Hexandiol, Oxaalkandiolen, wie z.B. Diethylenglykol, oder Estern der Acryl- oder Methacrylsäure mit drei- und mehrwertigen Alkoholen, wie z.B. Glycerin, Trimethylolpropan, Pentaerythrit oder Sorbit. Beispiele für besonders geeignete mono- und polyfunktionelle Acrylate oder Methacrylate sind Butylacrylat, Butylmethacrylat, 2-Ethylhexylacrylat, Lauryl(meth)acrylat, Hexandioldiacrylat, Hexandioldimethacrylat, Ethylenglykol-di(meth)acrylat, Butandiol-1,4-di(meth)acrylat, Neopentylglykol-di(meth)acrylat, 3-Methylpentandiol-di(meth)acrylat, 2-Hydroxipropyl(meth)acrylat, 2-Hydroxiethyl(meth)acrylat, 1,1,1-Trimethylolpropantri(meth)acrylat, Di-, Tri- und Tetraethylenglykoldi(meth)-acrylat, Tripropylenglykol-di(meth)acrylat oder Pentaerythrit-tetra(meth) acrylat, des weiteren Poly-(ethylenoxid)di(meth)acrylat, ω-Methylpoly(ethylenoxid)-α-yl-(meth)acrylat, N,N-Diethylaminoethylacrylat, ein Umsetzungsprodukt aus 1 mol Glycerin, 1 mol Epichlorhydrin und 3 Mol Acrylsäure sowie Glycidylmethacrylat und Bisphenol-A-diglycidetheracrylat.

Es eignen sich auch Gemische photopolymerisierbarer ethylenisch ungesättigter organischer Verbindungen, sowie z.B. Gemische monofunktioneller (Meth)acrylate, wie z.B. Hydroxiethylmethacrylat mit polyfunktionellen (Meth)acrylaten der oben angeführten Art.

Außer den (Meth)acrylsäureestern eignen sich als Komponente (b) auch Derivate von (Meth)-acrylsäureamiden, wie z.B. N-Methylol(meth)acrylamidether von Polyolen (z.B. Glykol), insbesondere wenn Polyamide oder Polyvinylalkohol als Komponente (a) eingesetzt werden.

Die photopolymerisierbaren ethylenisch ungesättigten organischen Verbindungen (b) sind im erfindungsgemäßen lichtempfindlichen Aufzeichnungsmaterial vorzugsweise in Mengen von 0,5 bis 50, insbesondere 5 bis 50 Gew.-%, bezogen auf die Gesamtmenge der Komponenten a) bis d) enthalten.

Als Photoinitiatoren oder Photoinitiatorsysteme (c) kommen die für lichtempfindliche Aufzeichnungsmaterialien allgemein üblichen in Frage, beispielsweise radikalliefernde Photoinitiatoren, wie z.B. Benzoin oder Benzoinderivate, wie Benzoinether geradkettiger oder verzweigter Monoalkohole mit 1 bis 6 Kohlenstoffatomen, z.B. Benzoinmethyl-, -ethyl-, -isopropyl-, -n-butyl-, -isobutylether, symmetrisch oder unsymmetrisch substituierte Benzilacetale, wie Benzildimethylacetal, Benzil-1-methyl-1-ethylacetal, Diarylphosphinoxide, wie z.B. 2,4,6-Trimethylbenzoyldiphenylphosphinoxid oder 2,6-Dimethoxybenzoyldiphenylphosphinoxid oder Acyldiarylphosphinoxide gemäß DE-OS 29 09 992, oder substituierte und unsubstituierte Chinone, wie Ethylanthrachinon, Benzanthrachinon, Benzophenon oder 4,4'-Bis(dimethylamino)benzophenon. Sie können allein oder im Gemisch miteinander oder in Verbindung mit Coinitiatoren verwendet werden, z.B. Ethylanthrachinon mit 4,4'-Bis(dimethylamino)benzophenon, Benzoinmethylether mit Triphenylphosphin, Diacylphosphinoxide mit tertiären Aminen oder Acyldiarylphosphinoxide mit Benzildimethylacetal.

Komponente (c) ist in den erfindungsgemäßen Aufzeichnungsmaterialien vorzugsweise in Mengen von 0,2 bis 10, insbesondere 0,5 bis 5 Gew.-%, bezogen auf die Gesamtmenge der Komponenten a) bis d), enthalten. Die erfindungsgemäß einzusetzende Weichmacherkomponente (d) ist ein Polyalkyleniminderivat, das Strukturelemente A oder B oder ein Gemisch aus Strukturelementen A und B aufweist, wobei

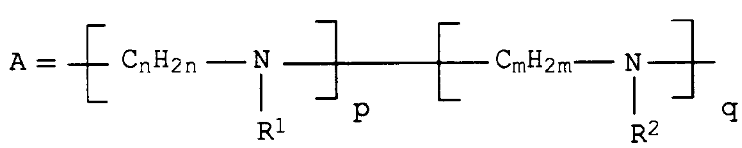

mit

n = 2 bis 8, vorzugsweise 2 bis 4,

m = 2 bis 8, vorzugsweise 2 bis 4,
p = 10 bis 10 000, vorzugsweise 10 bis 500,
q = 10 bis 10 000, vorzugsweise 10 bis 500,
$R^1$ und $R^2$ untereinander gleich oder verschieden sind und für

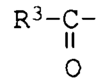

oder $R^3$ oder A stehen,
$R^3$ = ein, gegebenenfalls ethylenisch ungesättigter, 1 bis 30 Kohlenstoffatome enthaltender linearer, verzweigter oder cyclischer aliphatischer oder aromatischer Kohlenwasserstoffrest, wie z.B. Methyl, Ethyl, Propyl, Isopropyl, Butyl, Isobutyl, Stearyl, Methylvinyl, Phenyl, Benzyl, Tolyl, 2-Phenylethenyl,

B = 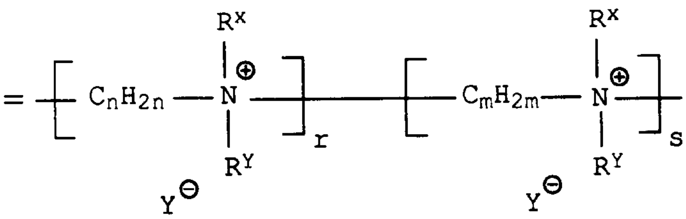

mit
n = 2 bis 8, vorzugsweise 2 bis 4,
m = 2 bis 8, vorzugsweise 2 bis 4,
r = 10 bis 10 000, vorzugsweise 10 bis 500,
s = 10 bis 10 000, vorzugsweise 10 bis 500,
$R^x$ = H, ein, gegebenenfalls ethylenisch ungesättigter, 1 bis 30 Kohlenstoffatome enthaltender linearer, verzweigter oder cyclischer aliphatischer und/oder aromatischer Kohlenwasserstoffrest, wie z.B. Methyl, Ethyl, Propoyl, Isopropyl, Butyl, Isobutyl, Stearyl, Methylvinyl, Phenyl, Benzyl, Tolyl, 2-Phenylethenyl,
$R^Y$ = Hydroxialkyl-, Hydroxioxaalkyl- oder Poly(hydroxy)oxaalkylrest mit 2 bis 500 Kohlenstoffatomen, wie z.B. der Diethylenglykolrest oder der Rest eines Ethylenoxidaddukts mit 10 Ethylenoxideinheiten, $R^x$ oder B,
$Y^\ominus$ =

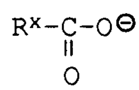

oder ein anderer monovalenter anionischer Rest, wie z.B. $Cl^\ominus$, $Br^\ominus$, $J^\ominus$ oder $ClO^\ominus_4$.

Als Ausgangsprodukt für die Herstellung der erfindungsgemäß einzusetzenden Polyalkyleniminderivate dienen Polyalkylenimine, wie z.B. Polyethylenimin, das mittlere Molekulargewichte zwischen 500 und 500.000, vorzugsweise zwischen 1000 und 200 000 aufweisen kann, Polypropylenimin/Alkylenoxid-Addukte, wie z.B. Polyethylenimin/Ethylenoxid-Addukte, z.B. solche mit 1 bis 1000 Ethylenoxideinheiten/10 Ethylenimineinheiten des Polyethylenimins und mittleren Molekulargewichten zwischen 1.000 und 1.000.000.

Zur Herstellung der erfindungsgemäß einzusetzenden Polyalkyleniminderivate werden die Polyalkylenimine bzw. Polyalkylenimin/Alkylenoxid-Addukte acyliert, beispielsweise durch die Umsetzung mit organischen Carbonsäuren wie z.B. Essigsäure, Propionsäure, Buttersäure, Capronsäure, Stearinsäure, Zimtsäure, Methacrylsäure oder deren Anhydriden bei Temperaturen zwischen 20 und 200 °C.

Der Einsatz von Anhydriden eröffnet die Möglichkeit, die Umsetzung bei niedriger Temperatur durchzuführen (z.B. bei 20 °C). Die Reaktion kann dabei durch Katalysatoren, wie z.B. DMAP (= Dimethylaminopyridin) beschleunigt werden.

Bei Einsatz der freien Säuren werden höhere Temperaturen benötigt. Hierbei kann das Veresterungsgleichgewicht durch Abdestillieren des Reaktionswassers zugunsten des Amids bzw. Esters verschoben

werden.

Außerdem können der lichtempfindlichen Aufzeichnungsschicht im allgemeinen in einer Menge von 0,001 bis 2 Gew.-%, bezogen auf die Gesamtmenge der lichtempfindlichen Aufzeichnungsschicht (2) Inhibitoren gegen die thermische Polymerisation, die keine nennenswerte Eigenabsorption in dem aktinischen Bereich, in dem der Photoinitiator absorbiert, aufweisen, zugesetzt werden, wie z.B. 2,6-Di-tert.-butyl-p-kresol, Hydrochinon, p-Methoxiphenol, $\beta$-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze, des N-Nitrosocyclohexylhydroxylamins.

Auch geeignete Farbstoffe, Pigmente oder photochrome Zusätze können den erfindungsgemäßen lichtempfindlichen Aufzeichnungsmaterialien in einer Menge von 0,0001 bis 2 Gew.-%, bezogen auf das Gemisch, zugesetzt werden. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie ebenso wenig wie die Inhibitoren der thermisch initiierten Polymerisation die Photopolymerisation der Gemische stören. Geeignet sind z.B. die löslichen Phenazinium-, Phenoxazinium-, Acridinium- und Phenothiaziniumfarbstoffe, wie Neutralrot (C.I. 50040), Safranin T (C.I. 50240), Rhodanilblau, das Salz bzw. Amid aus Rhodamin D (Basic Violett 10, C.I. 45170), Methylenblau B (C.I. 52015), Thioninblau G (C.I. 52025) oder Acridinorange (C.I. 46005); sowie auch Solvent Black 3 (C.I. 26150). Diese Farbstoffe können auch zusammen mit einer hinreichenden Menge eines Reduktionsmittels verwendet werden, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, insbesondere N-Allylthioharnstoff, sowie Hydroxylaminderivate, insbesondere Salze des N-Nitrosocyclohexyl-hydroxylamins, vorzugsweise die Kalium-, Calcium- und Aluminiumsalze. Letztere können, wie erwähnt, zugleich als Inhibitoren der thermisch initiierten Polymerisation dienen. Die Redinktionsmittel können im allgemeinen in Mengen von 0,005 bis 5 Gew.-%, bezogen auf das Gemisch, zugesetzt werden, wobei sich in vielen Fällen der Zusatz eines 3- bis 10fachen der Menge an mitverwendetem Farbstoff bewährt hat.

Beim erfindinngsgemäßen Verfahren zur Herstellung von Hochdruckplatten wird das erfindungsgemäße Aufzeichnungsmaterial zur Herstellung der reliefbildenden Schicht eingesetzt. Dazu wird z.B. das aus den Komponenten a) bis d) bestehende Gemisch in einem geeigneten Lösungsmittel, wie z.B. einem Alkohol wie n-Propanol gelöst, auf einer mit einem Polyinrethan-Haftlack versehenen Polyesterfolie eine Schicht R in einer Schichtdicke von 10 µm bis 2 mm, vorzugsweise 200 bis 1.000 µm, aufgetragen und getrocknet.

Das so hergestellte Aufzeichnungsmaterial wird in an sich bekannter Weise zu einer Reliefdruckform verarbeitet, in dem die Schicht R durch Bestrahlung mit aktinischem Licht, superaktinischen Leuchtstoffröhren oder Quecksilber-Mittel-oder Hochdruckbrennern, die gegebenenfalls mit Metallen, wie z.B. Eisen dotiert sein können, bildmäßig belichtet wird, die nicht belichteten Anteile der Schicht R mit Wasser bzw. Wasser/Alkohol-Gemischen ausgewaschen werden und die erhaltene Druckform danach getrocknet und nachbelichtet wird. Die resultierenden Druckformen zeigen eine exakte Bildwiedergabe, ergeben ausgezeichnete Druckergebnisse und besitzen eine deutlich geringere Härte als vergleichbare Druckformen ohne den Zusatz des Polyalkyleniminderivats.

Die in den folgenden Beispielen genannten Teile und Prozente sind, soweit nicht anders angegeben, Gewichtsteile bzw. Gewichtsprozente.

I. Herstellung von Polyethyleniminderivaten (Komponente (d))

1.1. Herstellung von Polyethyleniminderivat 1:

103 Teile wasserfreies Polyethylenimin (mittleres Molekulargewicht 1500) werden unter Rühren auf 80 °C erhitzt und langsam 146 Teile konzentrierte Essigsäure zudosiert, wobei die Temperatur auf 110 - 120 °C ansteigt. Die Säure wird so zugegeben, daß die Temperatur in diesem Bereich gehalten wird. Nach der Zugabe wird das Gemisch auf 160 °C erhitzt und das Reaktionswasser und die überschüssige Essigsäure abdestilliert (ca. 64 Teile). Nach der Destillation wird noch 30 Min. bei 160 °C nachgerührt und das Produkt auf 80 °C abgekühlt und abgefüllt. Die Ausbeute an acylieretm Polyethylenimin beträgt 185 Teile.

1.2. Herstellung von Polyethyleniminderivat 2:

100 Teile wasserfreies Polyethylenimin (mittleres Molekulargewicht 170000) werden mit 50 Teilen Wasser versetzt und das Gemisch unter Rühren auf 65 °C erhitzt. Dann werden langsam 153,5 Teile konzentrierte Essigsäure zudosiert, wobei die Temperatur auf 85 °C ansteigt. Die Säure wird so zugegeben, daß die Temperatur in diesem Bereich gehalten wird und dann wird noch 30 min.

nachgerührt. Nach der Zugabe wird die Badtemperatur auf 170 °C erhitzt und das Wasser und die überschüssige Essigsäure unter vermindertem Druck abdestilliert (107 Teile). Nach der Destillation wird das Produkt auf 80 °C abgekühlt und in n-Propanol aufgenommen. Die Ausbeute an acyliertem Polyethylenimin beträgt 121 Teile.

1.3. Herstellung von Polyethyleniminderivat 3:

3,63 Teile wasserfreies Polyethylenimin (mittleres Molekulargewicht 1500) werden unter Rühren auf 110 °C erhitzt und während 8 h mit 3,71 Teilen Ethylenoxid begast. Das Gemisch wird weitere 12 h gerührt, dann Vakuum angelegt um das überschüssige Ethylenoxid zu entfernen, dann abgekühlt und abgefüllt. Die Ausbeute an ethoxyliertem Polyethylenimin beträgt 7 kg.

1.4. Herstellung von Polyethyleniminderivat 4:

87 Teile des unter 1.3. hergestellten ethoxylierten Polyethyleniminderivates wurde in 98 Teilen Methanol gelöst und mit 150 Teilen Methyljodid versetzt. Das Gemisch wurde 3 h bei 50 °C gerührt und anschließend das überschüssige Methyljodid und das Methanol abdestilliert. Die verbleibende kristalline Substanz wurde 12 h bei 50 °C und unter Vakuum getrocknet und abgefüllt. Die Ausbeute an umgesetztem Polyethylenimin beträgt 183 Teile.

1.5. Herstellung von Polyethyleniminderivat 5:

87 Teile des unter 1.3. hergestellten ethoxylierten Polyethyleniminderivates wurde in 98 Teilen Methanol gelöst und dann wurden unter Rühren während 2 h 67 Teile HCl-Gas eingeleitet. Das Gemisch wurde anschließend noch 3 h bei 60 °C gerührt und anschließend die Lösung mit Natrium-Methylat (30%-ig in Methanol) auf pH 6 neutralisiert. Die verbleibende Lösung wurde filtriert, das Methanol unter Vakuum abdestilliert und das Produkt abgefüllt. Die Ausbeute an PolyethyleniminUmsetzungsprodukt beträgt 105 Teile.

1.6. Herstellung von Polyethyleniminderivat 6:

3,01 Teile wasserfreies Polyethylenimin (mittleres Molekulargewicht 21500) werden unter Rühren auf 110 °C erhitzt und während 8 h mit 4,47 Teilen Propylenoxid begast. Das Gemisch wird weitere 12 h gerührt, dann Vakuum angelegt, um das überschüssige Propylenoxid zu entfernen, dann abgekühlt und abgefüllt. Die Ausbeute an propoxyliertem Polyethylenimin beträgt 7,07 Teile.

1.7. Herstellung von Polyethyleniminderivat 7:

430 Teile wasserfreies Polyethylenimin (mittleres Molekulargewicht 1500) werden mit 1.54 Teilen N-Nitrosocyclohexylhydroxylamin-Kaliumsalz (30%-ige Lösung in Wasser) versetzt, dann werden unter Rühren 102 Teile Essigsäureanhydrid, 462 Teile Methacrylsäureanhydrid und wieder 714 Teile Essigsäureanhydrid so zudosiert, daß die Temperatur nicht über 70 °C ansteigt. Nach der Zugabe wird das Gemisch mit Methanol versetzt, filtriert und alle flüchtigen Komponenten bei 70 °C unter Vakuum abgezogen. Die Ausbeute an acyliertem Polyethylenimin beträgt 794 Teile.

1.8. Umsetzung von Ethylendipropylentetramin mit Dichlorethan und anschließender Acylierung:

94 Teile Ethylendipropylentetramin und 94 Teile Wasser werden bei 70- 90 °C in 60-90 Minuten mit 44,7 teilen 1,2-Dichlorethan versetzt und 6 Stunden bei 90 °C nachgerührt. Anschließend werden während 45 Minuten 97 Teile Essigsäure zugegeben, die Temperatur auf 180 °C erhöht und das Wasser und die überschüssige Essigsäure abdestilliert. Am Ende der Destillation wird während 15 Minuten Wasserstrahlvakuum angelegt, dann wird auf 80 °C abgekühlt und abgefüllt. Die Ausbeute an acyliertem Produkt beträgt 186 Teile.

Beispiel 1

Es wird eine Lösung aus 77 Teilen Wasser, 82 Teilen n-Propanol, 20 Teilen eines teilverseiften Polyvinylacetats (Verseifungsgrad 80%, mittleres Molekulargewicht 25000), 102 Teilen eines teilverseiften Polyvinylacetat-Polyethylenoxid-Pfropfmischpolymerisats (mit einem Ethylenoxidgehalt von 40 % und einem massenmittleren Molekulargewicht $M_w$ von 35000 gemäß EP-A-O 224 164), 76 Teilen Phenylglycidyletheracrylat, 3 Teilen Benzildimethylketal, 0,7 Teilen N-Nitrosocyclohexylhydroxylamin-Kaliumsalz und 0,04 Teile Safranin T (C.I. 50240) hergestellt. Zu dieser Lösung werden 20 Teile des gemäß 1.1. hergestellten Polyethyleniminderivats 1 (Komponente (d)) zugegeben. Aus dieser Lösung wird auf einer mit einem Polyurethan-Haftlack versehenen Polyesterfolie eine ca. 0,8 mm dicke Schicht R geformt und getrocknet. Das so hergestellte Aufzeichnungsmaterial wird in an sich bekannter Weise zu einer Reliefdruckform verarbeitet, in dem die Schicht R durch Bestrahlung mit aktinischem Licht bildmäßig belichtet wird, die nicht belichteten Anteile der Schicht R mit Wasser ausgewaschen werden, und die erhaltene Druckform danach getrocknet und nachbelichtet wird. Die resultierenden Druckformen zeigen eine exakte Bildwiedergabe und ausgezeichnete Druckergebnisse selbst nach mehr als 50.000 Drucken. Ferner besitzen sie eine deutlich geringere Härte als vergleichbare Druckformen ohne den Zusatz des Polyethylenimin-Essigsäure-Umsetzungsproduktes und zeigen ein deutlich geringeres Klischeecurling. In Tabelle 1 sind die Feststoffgehalte und Viskositätswerte (in mPas) der Lösungen des Aufzeichnungsmaterials mit steigenden Mengen an Komponente (d) und ohne ( = Vergleichsbeispiel 1) angegeben.

Tabelle 1

| Feststoff in % | Vergleichsbeispiel 1: Viskosität (mPas) der Lösung des Aufzeichnungsmaterials ohne Zusatz der Komponente (d) | mPas mit Zusatz der Komponente (d) | Anteil an Komponente (d) (Polyethyleniminderivat 1) | Viskosität (mPas) der Lösung des Aufzeichnungsmaterials nach Beispiel 1 mit 10 % Komponente (d) |
|---|---|---|---|---|
| 50 | 21.4 | | | |
| 52 | 33.8 | 23.1 | 7.7 % | 16.5 |
| 54 | 68.2 | 28 | 14.8 % | 22.8 |
| 56 | 90 | 24.9 | 21.4 % | 33.8 |
| 58 | 151 | 16.5 | 27.6 % | 49.6 |
| 60 | 932 | 17.8 | 33.3 % | 71.1 |
| 62 | | | | 122 |
| 64 | | | | 201 |
| 66 | | | | 694 |

Beispiel 2

Es wird wie in Beispiel 1 gearbeitet; jedoch werden 20 Teile des unter 1.2 hergestellten Polyethyleniminderivats 2 als Komponente (d) zugegeben. Das so erhaltene Aufzeichnungsmaterial zeigt ebenfalls eine deutlich geringere Härte und ein geringeres Klischeecurling als vergleichbare Druckformen ohne den Zusatz des Polyethylenimin-Essigsäure-Umsetzungsproduktes.

Beispiel 3

Es wird wie in Beispiel 1 gearbeitet; jedoch werden 20 Teile des unter 1.3 hergestellten Polyethyleniminderivats 3 als Komponente (d) zugegeben. Das so erhaltene Aufzeichnungsmaterial zeigt ebenfalls eine deutlich geringere Härte und ein geringeres Klischeecurling als vergleichbare Druckformen ohne den Zusatz des Polyethylenimin-Ethylenoxid-Umsetzungsproduktes.

Beispiel 4

Es wird wie in Beispiel 1 gearbeitet; jedoch werden 20 Teile des unter 1.4 hergestellten Polyethyleniminderivats 4 als Komponente (d) zugegeben. Das so erhaltene Aufzeichnungsmaterial zeigt ebenfalls eine geringere Härte und ein geringeres Klischeecurling als vergleichbare Druckformen ohne den Zusatz des Polyethylenimin-Ethylenoxid-Methyljodid-Umsetzungsproduktes.

Beispiel 5

Es wird wie in Beispiel 1 gearbeitet; jedoch werden 20 Teile des unter 1.5 hergestellten Polyethyleniminderivats 5 als Komponente (d) zugegeben. Das so erhaltene Aufzeichnungsmaterial zeigt ebenfalls eine geringere Härte und ein geringeres Klischeecurling als vergleichbare Druckformen ohne den Zusatz des PolyethyleniminEthylenoxid-Hydrochlorid-Umsetzungsprodinktes.

Beispiel 6

Es wird wie in Beispiel 1 gearbeitet; jedoch werden 20 Teile des unter 1.6 hergestellten Polyethyleniminderivats 6 als Komponente (d) zugegeben. Das so erhaltene Aufzeichnungsmaterial zeigt ebenfalls eine geringere Härte und ein geringeres Klischeecurling als vergleichbare Druckformen ohne den Zusatz des Polyethylenimin-Propylenoxid-Umsetzungsproduktes.

Beispiel 7

Es wird wie in Beispiel 1 gearbeitet; jedoch werden 20 Teile des unter 1.7 hergestellten Polyethyleniminderivats 7 als Komponente (d) zugegeben. Das so erhaltene Aufzeichnungsmaterial zeigt ebenfalls eine geringere Härte und ein geringeres Klischeecurling als vergleichbare Druckformen ohne den Zusatz des Polyethylenimin-Essigsäure-Methacrylsäure-Umsetzungsproduktes.

Beispiel 8

Es wird wie in Beispiel 1 gearbeitet; jedoch werden 20 Teile des unter 1.8 hergestellten Ethylendipropylentetramin-Dichlorethylen-Essigsäure-Umsetzungsproduktes als Komponente (d) zugegeben. Das so erhaltene Aufzeichnungsmaterial zeigt ebenfalls eine geringere Härte und ein geringeres Klischeecurling als vergleichbare Druckformen ohne den Zusatz des Ethylendipropylentetramin-Dichlorethylen-Essigsäure-Umsetzinngsproduktes.

Vergleichsbeispiel 1

Es wird wie in Beispiel 1 gearbeitet; jedoch wird auf die Zugabe eines Polyethyleniminderivates ( = Komponente (d)) verzichtet. Das so erhaltene Aufzeichnungsmaterial zeigt unbefriedigende Belichtungseigenschaften mit Hg-Brennern und eine deutlich höhere Härte und ein stärkeres Klischeecurling.

Beispiel 9

Es wird eine Lösung aus 58 Teilen Wasser, 61 Teilen n-Propanol, 98 Teilen eines wasserlöslichen ethoxylierten Copolyamids (aus Polyamid 6, Polyamid 6,6 und Ethylenoxid, Molverhältnis 2 : 3 : 4; z.B. AQ-Nylon, P70 der Fa. Toray), 98 Teilen Bisphenol-A-diglycidetherdiacrylat, 3 Teilen Benzildimethylketal, 1 Teil N-Nitrosocyclohexylhydroxylamin-Kaliumsalz und 0,04 Teilen Neutralrot (C.I. 50040) hergestellt. Zu dieser Lösung werden 20 Teile des gemäß 1.1 hergestellten Polyethylenimin-Essigsäure-Umsetzungsproduktes als Komponente (d) zugegeben. Aus dieser Lösung wird auf einer mit einem Polyurethan-Haftlack versehenen Polyesterfolie eine ca. 0,9 mm dicke Schicht R geformt und getrocknet.

Das so hergestellte Aufzeichnungsmaterial wird in an sich bekannter Weise zu einer Reliefdruckform verarbeitet, in dem die Schicht R durch Bestrahlung mit aktinischem Licht bildmäßig belichtet wird, die nicht belichteten Anteile der Schicht R mit Wasser ausgewaschen werden und die erhaltene Druckform danach getrocknet und nachbelichtet wird. Die resultierenden Druckformen zeigen eine exakte Bildwiedergabe und ausgezeichnete Druckergebnisse selbst nach mehr als 50.000 Drucken. Ferner besitzen sie eine deutlich geringere Härte als vergleichbare Druckformen ohne den Zusatz des polyethylenimin-Essigsäure-Umsetzungsproduktes und zeigen ein deutlich geringeres Rohplatten- und Klischeecurling.

Vergleichsbeispiel 2

Es wird wie in Beispiel 9 gearbeitet; jedoch wird auf die Zugabe des Polyethyleniminderivates verzichtet.

Das so erhaltene Aufzeichnungsmaterial zeigt eine deutlich höhere Härte und ein stärkeres Rohplatten- und Klischeecurling.

Beispiel 10

Es wird eine Lösung aus 120 Teilen Wasser, 30 Teilen eines teilverseiften Polyvinylacetats (Verseifungsgrad 80%, mittleres Molekulargewicht 15000), 30 Teilen eines weiteren teilverseiften Polyvinylacetats (Verseifungsgrad 80%, mittleres Molekulargewicht 20000), 24,5 Teilen eines teilverseiften Vinylacetat-Ethylenoxid-Pfropfmischpolymerisats (®Mowiol, 04-86 der Fa. Hoechst AG) 67,5 Teilen Hydroxyethylmethacrylat, 7,4 Teilen Butan-1,4-dioldimethacrylat, 1 Teil ®Lucirin TPO (= Trimethylbenzoyldiphenylphosphinoxid), 0,0035 Teilen Safranin T (C.I. 50240), 0,26 Teilen ®Kerobit TBK (=tert.-Butylkresol) und 0,042 Teilen Methylhydrochinon/Hydrochinon hergestellt. Zu dieser Lösung werden 14 Teile des gemäß 1.1. hergestellten Polyethyleniminderivats 1 als Komponente (d) zugegeben. Aus dieser Lösung wird auf einem mit einem Polyurethan-Haftlack versehenen Stahlblech eine ca. 0,5 mm dicke Schicht R geformt und getrocknet.

Das so hergestellte Aufzeichnungsmaterial wird in an sich bekannter Weise zu einer Reliefdruckform verarbeitet, in dem die Schicht R durch Bestrahlung mit aktinischem Licht bildmäßig belichtet wird, die nicht belichteten Anteile der Schicht R mit Wasser ausgewaschen werden und die erhaltene Druckform danach getrocknet und nachbelichtet wird. Die resultierenden Druckformen zeigen eine exakte Bildwiedergabe und ausgezeichnete Druckergebnisse selbst nach mehr als 50.000 Drucken. Ferner besitzen sie eine deutlich geringere Härte als vergleichbare Druckformen ohne den Zusatz des Polyethylenimin-Essigsäure-Umsetzungsproduktes.

Beispiel 11

Es wird wie in Beispiel 10 gearbeitet; jedoch werden 20 Teile des unter 1.3 hergestellten Polyethyleniminderivats 3 als Komponente (d) zugegeben. Das so erhaltene Aufzeichnungsmaterial zeigt ebenfalls eine geringere Härte als vergleichbare Druckformen ohne den Zusatz des Polyethylenimin-Ethylenoxid-Umsetzungsproduktes.

Vergleichsbeispiel 3

Es wird wie in Beispiel 10 gearbeitet; doch wird auf die Zugabe des Polyethyleniminderivates verzichtet.

Das so erhaltene Aufzeichnungsmaterial zeigt eine deutlich höhere Härte und benötigt eine Vorbelichtung, was bei den gemäß Beispiel 10 und Beispiel 11 erhaltenen Aufzeichnungsmaterialien nicht notwendig ist.

Beispiel 12

Es wird eine Lösung aus 12 Teilen Wasser, 46 Teilen Methanol, 100 Teilen eines niedermolekularen Mischpolyamids aus Polyamid 6, Polyamid 6,6 und Polyamid 6,13 (Molverhältnis 1 : 1 : 1; K-Wert = 65), 216 Teilen Glycolamol (= Bis(dimethylolacrylamidether) des Äthandiols) (25 % in Methanol), 21,6 Teilen Benzolsulfonsäure-n-butylamid, 3,2 Teilen Benzildimethylketal, 1 Teil N-Nitrosocyclohexylhydroxylamin-Kaliumsalz, 0,04 Teilen Isobutylthioanthrachinon hergestellt. Zu dieser Lösung werden 51,4 Teile des gemäß 1.2. hergestellten Polyethyleniminderivats 2 als Komponente (d) zugegeben. Aus dieser Lösung wird auf einer mit einem Polyurethan-Haftlack versehenen Polyesterfolie eine ca. 0,7 mm dicke Schicht R geformt und getrocknet.

Das so hergestellte Aufzeichnungsmaterial wird in an sich bekannter Weise zu einer Reliefruckform verarbeitet, in dem die Schicht R durch Bestrahlung mit aktinischem Licht bildmäßig belichtet wird, die nicht belichteten Anteile der Schicht R mit Ethanol/Wasser (8:2) ausgewaschen werden und die erhaltene Druckform danach getrocknet und nachbelichtet wird. Die resultierenden Druckformen zeigen eine exakte Bildwiedergabe und ausgezeichnete Druckergebnisse selbst nach mehr als 50.000 Drucken. Ferner besitzen sie eine deutlich geringere Härte als vergleichbare Druckformen ohne den Zusatz des Polyethylenimin-Essigsäure-Umsetzungsproduktes und zeigen ein deutlich geringeres Klischeecurling.

Beispiele 13 und 14

Es wird wie in Beispiel 12 gearbeitet; doch werden 20 Teile des unter 1.6 hergestellten Polyethyleniminderivats 6 bzw. 40 Teile des unter 1.1 hergestellten Polyethyleniminderivats 1 als Komponente (d) zugegeben. Das so erhaltene Aufzeichnungsmaterial zeigt ebenfalls eine deutlich geringere Härte und ein geringeres Klischeecurling als vergleichbare Druckformen ohne den Zusatz des Polyethyleniminderivats.

Vergleichsbeispiel 4

Es wird wie in Beispiel 12 gearbeitet; doch wird auf die Zugabe des Polyethyleniminderivates verzichtet.

Das so erhaltene Aufzeichnungsmaterial zeigt eine deutlich höhere Härte und ein stärkeres Klischeecurling.

In der folgenden Tabelle 2 sind die Shore-D-Härten der belichteten Reliefschichten der Beispiele 1 bis 14 und der Vergleichsbeispiele 1 bis 4 angegeben:

Tabelle 2

| Beispiel Nr. | Zusatz | Menge | Shore D* |
|---|---|---|---|
| 1 | Polyethyleniminderivat 1 | 10% | 11 |
| 2 | Polyethyleniminderivat 2 | 10% | 20 |
| 3 | Polyethyleniminderivat 3 | 10% | 9 |
| 4 | Polyethyleniminderivat 4 | 10% | 18 |
| 5 | Polyethyleniminderivat 5 | 10% | 12 |
| 6 | Polyethyleniminderivat 6 | 10% | 17 |
| 7 | Polyethyleniminderivat 7 | 10% | 20 |
| 8 | | 10% | 17 |
| Vergleichsbeispiel 1 | | | 23 |
| 9 | Polyethyleniminderivat 1 | 10% | 9 |
| Vergleichsbeispiel 2 | | | 12 |
| 10 | Polyethyleniminderivat 1 | 10% | 42 |
| 11 | Polyethyleniminderivat 3 | 10% | 40 |
| Vergleichsbeispiel 3 | | | 55 |
| 12 | Polyethyleniminderivat 2 | 20% | 31 |
| 13 | Polyethyleniminderivat 6 | 10% | 11 |
| 14 | Polyethyleniminderivat 1 | 20% | 36 |
| Vergleichsbeispiel 4 | | | 50 |

*Shore D gemessen nach DIN 53505 und 7 Tage Lagerung der Proben bei 23°C und 60°C rel. Luftfeuchte

II. Herstellung von Methacrylestern ölsäuremodifizierter Polyethylenimin-Derivaten (Komponente (d))

1.8.1. Herstellung von Polyethyleniminderivat 9:
100 Teile wasserfreies Polyethylenimin (mittleres Molekulargewicht 860) und 100 Teile eines Gemisches ungesättigter C16-C18-Carbonsäuren (Leinöl) werden unter Rühren im Vakuum langsam bis auf ca. 180°C erhitzt. Dabei destilliert das entstehende Reaktionswasser (ca. 6 Gew.-teile) ab. Man tropft dann 44 Teile Acetanhydrid zur Acetylierung der reaktivsten Aminogruppen (primäre Aminogruppen, sowie ein Teil der sekundären) zu und destilliert dann einen Großteil der entstehenden Essigsäure im Vakuum bei Temperaturen bis zu 190°C ab. Man kühlt dann auf etwa 100°C ab, verdünnt mit 150 Teilen wasserfreiem Toluol unter Abkühlen auf etwa 60°C, tropft dann bei dieser Temperatur 57 Teile Glycidylmethacrylat zu, und läßt die Reaktionsmischung 3 Stunden lang nachreagieren. Zur Stabilisierung des Reaktionsproduktes gegen eine unerwünschte vorzeitige thermische Polymerisation der Methacrylgruppen wird ein Gemisch aus 0,2 Teilen Di-t-Butyl-p-kresol und 0,1 Teilen Hydrochinonmonomethylether im Verlauf der letzten 3 Stunden Reaktionszeit kontinuierlich zugegeben.

Der so hergestellte polymerisierbare Weichmacher läßt sich nach Zusatz von etwa einem Gewichtsprozent Benzildimethylketal als Photoinitiator und nach Entfernen des Lösungsmittels Toluol durch Bestrahlung mit UV-A-Licht zu einem zähelastischen, leicht gelblichen glasklaren Film aushärten und enthält weniger als 0,1 Gewichtsprozent nicht umgesetztes Glycidylmethacrylat, gerechnet auf den

Feststoffgehalt. Es ist in nicht polymerisierter Form sowohl in Toluol, in Ethanol und in Ethanol:Wasser 1:1 klar löslich.

1.8.2. Herstellung von Polyethyleniminderivats 10:

150 Teile wasserfreies Polyethylenimin (mittleres Molekulargewicht 860) und 62 Teile Acetanhydrid werden unter Rühren im Vakuum langsam bis auf ca. 160 °C erhitzt. Dabei destilliert ein Großteil der entstehenden Essigsäure ab. Man kühlt dann auf etwa 90 °C ab und tropft dann bei dieser Temperatur 40 Teile Glycidol zu und läßt die Reaktionsmischung 1 Stunde lang nachreagieren. Dann gibt man 43 Teile Glycidylmethylacrylat im Verlauf einer halben Stunde zu und steigert dabei die Temperatur bis auf 110 °C. Im Verlauf der Nachreaktionszeit steigt die Viskosität kontinuierlich an. Durch Zugabe von 125 Teilen n-Propanol wird der weitere Viskositätsanstieg ca. eine Stunde nach Zulaufbeginn des Glycidylmethylacrylats und eine halbe Stunde nach dessen Zulaufende abgestoppt. Zur Stabilisierung des Reaktionsproduktes gegen eine unerwünschte vorzeitige thermische Polymerisation der Methacrylgruppen wird ein Gemisch aus 0,2 Teilen Di-t-Butyl-p-kresol und 0,1 Teile Hydrochinonmonomethylether im Verlauf der letzten Stunde Reaktionszeit kontinuierlich zugegeben. Der so hergestellte polymerisierbare Weichmacher läßt sich nach Zusatz von etwa einem Gewichtsprozent Benzildimethylketal als Photoinitiator und nach dem Entfernen des Lösungsmittels n-Propanol durch Bestrahlung mit UV-A-Licht zu einem zähelastischen, hellgelben glasklaren Film aushärten und enthält weniger als 0,3 Gewichtsprozent nicht umgesetztes Glycidylmethacrylat, gerechnet auf den Feststoffgehalt. Es ist in unpolymerisierter Form sowohl in Aceton, Ethanol und Ethanol/Wasser-Gemischen als auch in reinem Wasser klar löslich.

1.8.3. Herstellung von ölsäuremodifiziertem Polyethyleniminderivat 11

100 Teile wasserfreies Polyethylenimin (mittleres Molekulargewicht 860) und 100 Teile eines gemisches ungesättigter C16-C18-Carbonsäuren (Leinöl) werden unter Rühren im Vakuum langsam bis auf ca. 180 °C erhitzt. Dabei destilliert das entstehende Reaktionswasser (ca. 6 Teile) ab. Man tropft dann bei 100 °C 62 Teile Butandiolmonoacrylat zu. Dabei reagieren die reaktivsten Aminogruppen (primäre Aminogruppen, sowie ein Teil der sekundären) unter Michaeladdition mit den Acrylgruppen des Butandiolmonoacrylates. Es werden so primäre Hydroxylgruppen ins Polyethylenimin eingeführt. Man verdünnt mit 126 Teilen Toluol und tropft bei $40^0$C 62 Teile Methacrylsäureanhydrid zu. Die freigesetzte Methacrylsäure wird durch Strippen mit Wasser destillativ entfernt. Zur Stabilisierung gegen unerwünschte vorzeitige radikalische Polymerisation der Methacrylgruppen wird ein Gemisch aus 0,2 Teilen Di-t-Butyl-p-kresol und 0,1 Teilen Hydrochinonmonomethylether im Verlauf der letzten Reaktionsphase kontinuierlich zugegeben.

Beispiele 15 bis 17

Herstellung von Druckplatten unter Einsatz der gemäß 1.8.1, 1.8.2 bzw. 1.8.3 hergestellten einpolymerisierbaren methacrylgruppenhaltiger Polyethyleniminderivate 9, 10 und 11. Es wird eine Lösung aus 77 Teilen Wasser, 82 Teilen n-Propanol, 20 Teilen eines teilverseiften Polyvinylacetats (Verseifungsgrad 80%, mittleres Molekulargewicht 25000), 102 Teilen eines teilverseiften Polyvinylacetat-Polyethylenoxid-Pfropfmischpolymerisats (mit einem Ethylenoxidgehalt von 40% und einem massenmittleren Molekulargewicht $M_w$ von 35000 gemäß EP-A-224 164), 66 Teilen Butan-1,4-diol-diglycidyletherdiacrylat, 3 Teilen Benzildimethylketal, 2,2 Teile N-Nitrosocyclohexylhydroxylamin-Kaliumsalz (30%-ige Lösung in Wasser) und 0,04 Teilen Safranin T (C.I. 50240) hergestellt. Zu dieser Lösung werden jeweils 10 Teile der gemäß 1.8.1. bis 1.8.3. hergestellten Polyethyleniminderivate 9, 10 bzw. 11 zugegeben.

Beim Vergleichsbeispiel 5 entfällt der Zusatz des Polyethyleniminderivates.

Aus diesen Lösungen werden auf mit Polyurethan-Haftlacken versehenen verzinnten 240 µm dicken Stahlträgerblechen ca. 0,7 mm dicke photopolymerisierbare Druckplattenschichten durch Gießen aus den oben angegebenen Lösungen hergestellt.

In Tabelle 3 sind die Meßergebnisse der gemäß Beispiel 15 bis 17 und Vergleichsbeispiel 5 erhaltenen Reliefschichten angegeben.

Tabelle 3:

| Beispiel | Komponente (d) | Mindest-Belichtungszeit [Minuten] | Härte/E-Modul [N/qmm] | Dornbiegeradius [Millimeter] |
|---|---|---|---|---|
| 15 | Polyethyleniminderivat 9 | 3,5 | 150 | 5,0 |
| 16 | Polyethyleniminderivat 10 | 3,2 | 140 | 6,0 |
| 17 | Polyethyleniminderivat 11 | 3,0 | 145 | 5,0 |

| Vergleichs-Beispiel 5 | Mindest-Belichtungszeit [Minuten] | Härte/E-Modul [N/qmm] | Dornbiegeradius [Millimeter] |
|---|---|---|---|
| | 7,5 | 280 | 12 |

**Patentansprüche**

1. Lichtempfindliches Aufzeichnungsmaterial, das in einer Schichtdicke > 10 µm auf einen Träger aufgebracht ein Gemisch aus
   a) mindestens einem polymeren Bindemittel,
   b) mindestens einer photopolymerisierbaren ethylenisch ungesättigten organischen Verbindung,
   c) einem Photoinitiator oder einem Photoinitiatorsystem
   und
   d) einem Weichmacher

   enthält, dadurch gekennzeichnet, daß als Weichmacher ein Polyalkyleniminderivat eingesetzt wird, das Strukturelemente A oder B oder ein Gemisch aus Struktinrelementen A und B aufweist, wobei

   A = 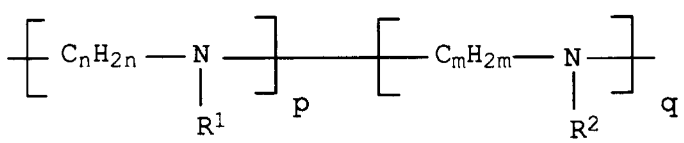

   mit
   n = 2 bis 8,
   m = 2 bis 8,
   p = 10 bis 10 000,
   q = 10 bis 10 000,
   $R^1$ und $R^2$ untereinander gleich oder verschieden sind und für

   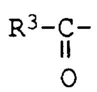

   oder $R^3$ oder A stehen,
   $R^3$ = ein, gegebenenfalls ethylenisch ungesättigter, 1 bis 30 Kohlenstoffatome enthaltender linearer, verzweigter oder cyclischer aliphatischer und/oder aromatischer Kohlenwasserstoffrest,

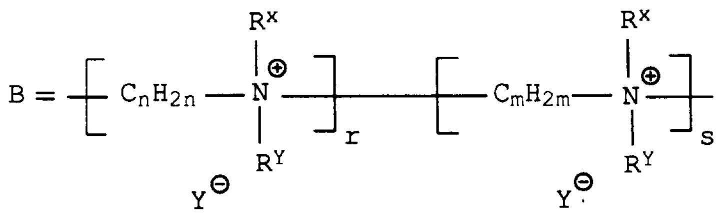

mit

- n = 2 bis 8,
- m = 2 bis 8,
- r = 10 bis 10 000,
- s = 10 bis 10 000,
- $R^x$ = H, ein, gegebenenfalls ethylenisch ungesättigter, 1 bis 30 Kohlenstoffatome enthaltender linearer, verzweigter oder cyclischer aliphatischer und/oder aromatischer Kohlenwasserstoffrest,
- $R^Y$ = Hydroxialkyl-, Hydroxioxaalkyl- oder Poly(hydroxy)oxaalkylrest mit 2 bis 500 Kohlenstoffatomen, $R^x$ oder B,
- $Y^\ominus$ =

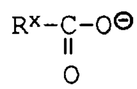

oder ein anderer monovalenter anionischer Rest.

**2.** Aufzeichnungsmaterial nach Anspruch 1, dadurch gekennzeichnet, daß als polymeres Bindemittel (a) teilverseiftes Polyvinylacetat oder teilverseiftes Vinylacetat/Alkylenoxid-Propfmischpolymerisat oder nachträglich polymeranalog acylierte Polyvinylalkohole oder deren Gemische eingesetzt werden.

**3.** Aufzeichnungsmaterial nach Anspruch 1, dadurch gekennzeichnet, daß als polymeres Bindemittel ein in Wasser, Wasser/Alkohol oder Alkohol lösliches Polyamid eingesetzt wird.

**4.** Aufzeichnungsmaterial nach einem der vorhergehenden Ansprüche, dadurch gekennzeichnet, daß als photopolymerisierbare ethylenisch ungesättigte organische Verbindung (b) mindestens ein polyfunktionelles Acrylat oder Methacrylat eingesetzt wird.

**5.** Aufzeichnungsmaterial nach einem der vorhergehenden Ansprüche, dadurch gekennzeichnet, daß als Weichmacher (d) ein Polyalkyleniminderivat eingesetzt wird, das aus einem Gemisch aus Strukturelementen A und B besteht, worin mindestens 70 mol-% Strukturelemente A enthalten sind.

**6.** Aufzeichnungsmaterial nach einem der vorhergehenden Ansprüche, dadurch gekennzeichnet, daß das Gemisch aus

10 bis 95 Gew.-% der Komponente (a),
0,5 bis 50 Gew.-% der Komponente (b),
0,2 bis 10 Gew.-% der Komponente (c) und
0,5 bis 50 Gew.-% der Komponente (d)

besteht, mit der Maßgabe, daß die Summe der unter (a) bis (d) genannten Prozentzahlen 100 ist.

**7.** Verfahren zur Herstellung von Hochdruckplatten, dadurch gekennzeichnet, daß als reliefbildende Schicht das Aufzeichnungsmaterial nach einem der vorhergehenden Ansprüche eingesetzt wird.